# FASCICULE DE BREVET EUROPEEN

(11) **EP 2 822 909 B1**
(45) Date de publication et mention de la délivrance du brevet: **29.06.2016**
(21) Numéro de dépôt: 13712875.7
(22) Date de dépôt: 01.03.2013
(51) Int. Cl.: C03C 17/34

(54) **VITRAGE ANTICONDENSATION**
BESCHLAGFREIE VERGLASUNG
ANTI-CONDENSATION GLAZING

(30) Priorité: 05.03.2012 FR 1251975
(43) Date de publication de la demande: 14.01.2015
(73) Titulaire: Saint-Gobain Glass France, 92400 Courbevoie (FR)
(72) Inventeur: LAMINE, Driss, F-92160 Antony (FR); ROY, Sébastien, F-78320 Le Mesnil Saint Denis (FR)
(74) Mandataire: Teyssedre, Laurent
(86) Numéro de dépôt international: PCT/FR2013/050437
(87) Numéro de publication internationale: WO 2013/132176

(56) Documents cités:
- WO-A1-2010/134446
- WO-A1-2011/105991
- DE-A1-102008 028 141
- FR-A1- 2 963 343
- US-A1- 2003 157 339

## Description

L'invention se rapporte au domaine des vitrages comprenant un substrat en verre, muni sur au moins une de ses faces d'un empilement de couches minces.

Pour des raisons environnementales et liées au souci d'économiser l'énergie, les habitations sont désormais munies de vitrages multiples, doubles, voire triples, souvent dotés de couches à propriétés de faible émissivité destinées à limiter les transferts de chaleur vers l'extérieur de l'habitation. Ces vitrages à très faible coefficient de transmission thermique sont toutefois sujets à l'apparition de condensation d'eau sur leur surface extérieure, sous la forme de buée ou de givre. En cas de ciel dégagé durant la nuit, les échanges de chaleur par rayonnement avec le ciel entraînent une baisse de température qui n'est plus suffisamment compensée par les apports de chaleur provenant de l'intérieur de l'habitation. Lorsque la température de la surface extérieure du vitrage passe en dessous du point de rosée, l'eau condense sur ladite surface, gênant la visibilité au travers du vitrage le matin, parfois pendant plusieurs heures.

Afin de résoudre ce problème, il est connu de disposer en face 1 du vitrage (la face extérieure) une couche à propriété de basse émissivité, par exemple une couche d'un oxyde transparent électro-conducteur (TCO) afin de réduire les échanges radiatifs avec le ciel. La demande WO 2007/115796 préconise par exemple d'employer un empilement comprenant une couche TCO (typiquement en oxyde d'étain dopé au fluor), une couche bloqueur et enfin une couche photocatalytique.

La demande FR 2 963 343 décrit aussi un empilement comprenant une couche TCO, notamment en ITO (oxyde d'étain et d'indium), une couche intermédiaire à faible indice de réfraction, typiquement en silice, et enfin une couche photocatalytique, l'épaisseur de la couche intermédiaire étant optimisée afin de réduire le moins possible le facteur solaire du vitrage.

L'utilisation d'ITO impose des traitements thermiques, typiquement de trempe, afin de réduire au maximum à la fois la résistivité électrique et l'absorption lumineuse de l'ITO. Il est apparu aux inventeurs que dans ce type d'empilements, les performances optimales de l'ITO ne pouvaient être obtenues que par un contrôle bien précis de l'état d'oxydation de l'ITO.

L'invention a pour but d'optimiser les performances optiques et d'anti-condensation de vitrages muni d'un revêtement à base d'ITO capable de limiter, voire supprimer, l'apparition de condensation (buée ou givre) sur la face externe.

A cet effet, l'invention a pour objet un vitrage comprenant un substrat en verre (1) muni sur l'une de ses faces, destinée à former la face 1 dudit vitrage en position d'utilisation, d'un empilement de couches minces comprenant, depuis ledit substrat (1), une couche (2) d'un oxyde transparent électro-conducteur à base d'oxyde d'étain et d'indium d'épaisseur physique e₁ comprise dans un domaine allant de 50 à 200 nm, une couche barrière en nitrure de silicium (3) d'épaisseur physique e₂, puis une couche à base d'oxyde de silicium (4), lesdites épaisseurs e₁ et e₂, exprimées en nanomètres étant telles que 0,11 ≤ e₂/e₁ ≤ 0,18.

Par « face 1 » du vitrage, on entend, comme c'est l'usage dans la technique, la face externe du vitrage qui est destinée à être positionnée de manière à se trouver en contact avec l'extérieur de l'habitation. Les faces d'un vitrage sont numérotées en partant de l'extérieur, si bien que la face 2 est la face opposée à la face 1, autrement dit l'autre face de la même feuille de verre. Dans un vitrage multiple, comprenant deux feuilles de verre ou plus, la face 3 est la face de la deuxième feuille de verre du vitrage faisant face à la face 2, la face 4 est la face opposée à la face 3 etc.

Le vitrage selon l'invention est de préférence un vitrage multiple, notamment double ou triple, voire plus, par exemple quadruple. Ces vitrages ont en effet un faible coefficient de transmission thermique, et sont les plus affectés par le phénomène de condensation. Un vitrage double est généralement constitué de deux feuilles de verre se faisant face et ménageant une lame de gaz, par exemple d'air, d'argon, de xénon ou encore de krypton. On dispose généralement à la périphérie du vitrage, entre les feuilles de verre, un cadre espaceur, sous la forme d'un profilé métallique, par exemple en aluminium, solidarisé aux feuilles de verre par une colle, la périphérie du vitrage étant scellée à l'aide d'un mastic, par exemple en silicone, polysulfures ou polyuréthane, pour éviter toute entrée d'humidité au sein de la lame de gaz. Pour limiter l'humidité, on dispose fréquemment un tamis moléculaire dans le cadre espaceur. Un triple vitrage est constitué de la même manière, si ce n'est que le nombre de feuilles de verre est de trois.

Lorsque le vitrage selon l'invention est un vitrage triple, au moins une autre face, choisie parmi les faces 2 à 5, est de préférence revêtue d'un empilement à propriétés de faible émissivité. Il peut s'agir notamment d'empilements de couches minces comprenant au moins une couche d'argent, la ou chaque couche d'argent étant disposée entre des couches diélectriques. On entend par faible émissivité une émissivité généralement d'au plus 0,1, notamment 0,05. De préférence, deux autres faces, notamment les faces 2 et 5 ou les faces 3 et 5 sont revêtues d'un tel empilement. D'autres configurations sont également possibles, mais moins préférées : faces 2 et 3, 2 et 4, 3 et 4, 4 et 5, faces 2, 3 et 4, faces 2, 3 et 5, faces 2, 4 et 5, faces 2, 3, 4 et 5. D'autres types d'empilements peuvent être disposés sur les faces du vitrage, par exemple des empilements antireflets, en face 2, 3, 4, 5 ou 6.

Lorsque le vitrage selon l'invention est un vitrage double, la face 2 est avantageusement revêtue d'un empilement à propriétés de faible émissivité, notamment du type de celui qui vient d'être décrit. Alternativement, la face 2 peut être revêtue d'un empilement de contrôle solaire (notamment à base de niobium ou de nitrure de niobium), ce qui n'est toutefois pas préféré car un tel empilement conduit à réduire le facteur solaire.

Le vitrage selon l'invention peut être employé comme tout type de vitrage. Il peut être intégré à une façade, une toiture, une véranda. Il peut être disposé à la verticale ou incliné.

Le substrat en verre est de préférence transparent et incolore (il s'agit alors d'un verre clair ou extra-clair). Un verre clair contient typiquement une teneur pondérale en oxyde de fer de l'ordre de 0,05 à 0,2%, tandis qu'un verre extra-clair contient généralement environ 0,005 à 0,03% d'oxyde de fer. Le verre peut être coloré, par exemple en bleu, vert, gris ou bronze, mais ce mode de réalisation, pénalisant pour le facteur solaire, n'est pas préféré. Le verre est normalement minéral, de préférence de type silico-sodo-calcique, mais il peut également être en verre de type borosilicate ou alumino-borosilicate. L'épaisseur du substrat est généralement comprise dans un domaine allant de 0,5 mm à 19 mm, de préférence de 0,7 à 9 mm, notamment de 2 à 8 mm, voire de 4 à 6 mm. Il en est de même, le cas échéant, pour les autres feuilles de verre du vitrage multiple.

Le substrat de verre est de préférence du type flotté, c'est-à-dire susceptible d'avoir été obtenu par un procédé consistant à déverser le verre fondu sur un bain d'étain en fusion (bain « float »). Dans ce cas, l'empilement peut aussi bien être déposé sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre.

Au moins une feuille de verre du vitrage selon l'invention peut être trempée thermiquement ou durcie, pour lui impartir des propriétés de résistance mécanique améliorée. De préférence, le substrat muni de l'empilement selon l'invention est trempé thermiquement. Comme décrit par la suite, la trempe thermique est utile afin d'améliorer les propriétés d'émissivité de la couche d'ITO. De préférence, la résistivité électrique de l'empilement après trempe est d'au plus 2, 2.10⁻⁹ Ω.cm, notamment d'au plus 2,1.10⁻⁴ Ω.cm et même 2,0.10⁻⁴ Ω.cm. Les propriétés d'émissivité et de résistivité électrique sont étroitement liées.

Pour améliorer les propriétés acoustiques ou de résistance à l'effraction du vitrage selon l'invention, au moins une feuille de verre du vitrage peut être feuilletée à une autre feuille au moyen d'une feuille intercalaire en un polymère tel que le polyvinlybutyral (PVB) ou le polyuréthane (PU).

La couche à base d'ITO est de préférence constituée d'ITO. Le pourcentage atomique de Sn est de préférence compris dans un domaine allant de 5 à 70%, notamment de 6 à 60%, avantageusement de 8 à 12%.

Ces couches présentent une bonne durabilité climatique, nécessaire lorsque l'empilement est disposé en face 1 du vitrage, ce qui n'est pas le cas d'autres couches bas-émissives, telles que les couches en argent. Ces dernières doivent impérativement être situées sur une face interne du vitrage multiple.

L'ITO est également particulièrement apprécié pour sa conductivité électrique élevée, autorisant l'emploi de faibles épaisseurs pour obtenir un même niveau d'émissivité, ce qui permet de minimiser la perte de facteur solaire. Aisément déposées par un procédé de pulvérisation cathodique, notamment assisté par champ magnétique, appelé « procédé magnétron », ces couches se distinguent par une plus faible rugosité, et donc un plus faible encrassement. Lors de la fabrication, de la manutention et de l'entretien des vitrages, les couches plus rugueuses ont en effet tendance à piéger divers résidus, qui sont particulièrement difficiles à éliminer.

L'épaisseur physique e₁ de la couche de TCO est ajustée de manière à obtenir l'émissivité voulue et donc les performances anti-condensation recherchées. L'émissivité de la couche de TCO est de préférence inférieure ou égale à 0,4, notamment 0,3. L'épaisseur physique e₁ de la couche à base d'ITO sera généralement d'au moins 60 nm, notamment 70 nm, et souvent d'au plus 180 nm.

Pour une performance anti-condensation donnée, l'émissivité recherchée dépend de différents facteurs, dont l'inclinaison du vitrage et son coefficient de transmission thermique Ug. Typiquement, un vitrage incliné et/ou à faible coefficient de transmission thermique nécessitera une émissivité plus faible, et par conséquent une épaisseur e₁ plus élevée.

Lorsque le vitrage est destiné à être placé en position verticale, l'émissivité est de préférence d'au plus 0,4, voire 0,3. L'épaisseur physique e₁ sera alors généralement d'au moins 60 nm, souvent d'au plus 120 nm.

Lorsque le vitrage est destiné à être placé en position inclinée, par exemple dans des applications en toiture, ou lorsque le coefficient de transmission thermique Ug est inférieur ou égal à 1 W/(m².K), voire 0,6 W/(m².K), l'émissivité est de préférence d'au plus 0,3, voire 0,2 et même 0,18. L'épaisseur physique e₁ sera de préférence d'au moins 60 nm, voire 70 ou 100 nm et d'au plus 200 nm.

Par « émissivité », on entend l'émissivité normale à 283 K au sens de la norme EN 12898. Comme démontré dans la suite du texte, le choix de l'épaisseur de la couche barrière permet, pour une épaisseur donnée d'ITO, d'optimiser sa résistivité, et donc son émissivité.

Afin de minimiser le facteur solaire du vitrage, l'indice de réfraction de la couche d'oxyde transparent électro-conducteur est de préférence compris dans un domaine allant de 1,7 à 2,5 et/ou l'indice de réfraction de la couche à base d'oxyde de silicium est de préférence compris dans un domaine allant de 1,40 à 1,55, notamment de 1,40 à 1,50. Dans l'ensemble du texte, les indices de réfraction sont mesurés, par exemple par ellipsométrie, pour une longueur d'onde de 550 nm.

La couche à base d'oxyde de silicium est avantageusement une couche de silice. Il est entendu que la silice peut être dopée, ou ne pas être stoechiométrique. A titre d'exemples, la silice peut être dopée par les atomes d'aluminium ou de bore, dans le but de faciliter son dépôt par des procédés de pulvérisation cathodique. Dans le cas de dépôt chimique en phase vapeur (CVD), la silice peut être dopée par des atomes de bore ou de phosphore, qui accélèrent le dépôt. La silice peut encore être dopée par des atomes de carbone ou d'azote, en des teneurs suffisamment faibles pour que l'indice de réfraction de la couche reste dans les gammes susmentionnées. La couche à base d'oxyde de silicium présente l'avantage de protéger la couche de TCO, lui assurant une meilleure durabilité climatique ainsi qu'une meilleure résistance à la trempe.

L'épaisseur physique de la couche à base d'oxyde de silicium est de préférence comprise dans un domaine allant de 20 à 100 nm, notamment de 30 nm à 90 nm, voire de 40 à 80 nm.

La couche barrière en nitrure de silicium, disposée entre la couche à base d'ITO et la couche à base d'oxyde de silicium, permet de contrôler très précisément l'état d'oxydation de l'ITO, et donc ses propriétés électriques et optiques après traitements thermiques, notamment de trempe. Le nitrure de silicium peut être stoechiométrique en azote, sous-stoechiométrique en azote, ou encore sur-stoechiométrique en azote. Un choix judicieux de l'épaisseur de la couche barrière, dépendant de l'épaisseur de la couche d'ITO, permet d'optimiser les propriétés de cette dernière. De préférence, le rapport e₂/e₁ est d'au moins 0,12 voire 0,13 et/ou d'au plus 0,17, notamment 0,16, voire 0,15 ou 0,14. Il est avantageusement compris dans un domaine allant de 0,12 à 0,15.

De préférence, la couche barrière en nitrure de silicium est déposée sur et en contact avec la couche à base d'ITO. La couche à base d'oxyde de silicium est quant à elle préférentiellement déposée sur et en contact avec la couche barrière en nitrure de silicium.

La couche à base d'oxyde de silicium peut être la dernière couche de l'empilement, donc celle en contact avec l'atmosphère. Alternativement, au moins une autre couche mince peut être déposée au-dessus de la couche à base d'oxyde de silicium.

On peut ainsi disposer au-dessus de, de préférence sur et en contact avec, la couche à base d'oxyde de silicium, une couche photocatalytique à base d'oxyde de titane, dont l'épaisseur physique est avantageusement d'au plus 30 nm, notamment 20 nm, voire 10 nm ou même 8 nm.

De très fines couches photocatalytiques, bien que moins actives photocatalytiquement parlant, présentent toutefois de bonnes propriétés auto-nettoyantes, antisalissures et antibuée. Même pour des couches de très faible épaisseur, l'oxyde de titane photocatalytique présente en effet la particularité, lorsqu'il est irradié par la lumière solaire, de devenir extrêmement hydrophile, avec des angles de contact à l'eau inférieurs à 5° et même 1°, ce qui permet à l'eau de ruisseler plus facilement, en éliminant les salissures déposées à la surface de la couche. En outre, les couches plus épaisses présentent une réflexion lumineuse plus élevée, ce qui a pour effet de diminuer le facteur solaire.

La couche photocatalytique est de préférence une couche en oxyde de titane, en particulier dont l'indice de réfraction est compris dans un domaine allant de 2,0 à 2,5. L'oxyde de titane est de préférence au moins partiellement cristallisé sous la forme anatase, qui est la phase la plus active du point de vue de la photocatalyse. Des mélanges de phase anatase et rutile se sont aussi révélés très actifs. Le dioxyde de titane peut éventuellement être dopé par un ion métallique, par exemple un ion d'un métal de transition, ou par des atomes d'azote, de carbone, de fluor.... Le dioxyde de titane peut également être sous-stoechiométrique ou sur-stoechiométrique.

Dans ce mode de réalisation, l'intégralité de la surface de la couche photocatalytique, notamment à base d'oxyde de titane, est de préférence en contact avec l'extérieur, de manière à pouvoir pleinement mettre en application sa fonction autonettoyante. Il peut toutefois être intéressant de revêtir la couche photocatalytique, notamment en dioxyde de titane, d'une fine couche hydrophile, notamment à base de silice afin d'améliorer dans le temps la persistance de l'hydrophilie.

Afin d'optimiser le facteur solaire du vitrage selon l'invention, les épaisseurs optiques à 550 nm de la couche photocatalytique (e₃) et de la couche à base d'oxyde de silicium (e₄), exprimées en nanomètres, sont de préférence telles que 110.*e*^{-0,025*e*₃} ≤ *e*₄ ≤ 135.*e*^{*-*0,018*e*₃}, l'épaisseur optique e₃ étant d'au plus 50 nm, et l'indice de réfraction (toujours à 550 nm) de la couche à base d'oxyde de silicium étant compris dans un domaine allant de 1,40 à 1,55.

On peut également disposer, entre le substrat et la couche d'un oxyde transparent électro-conducteur, une couche, ou un empilement de couches, de neutralisation. Dans le cas d'une couche unique, son indice de réfraction est de préférence compris entre l'indice de réfraction du substrat et l'indice de réfraction de ladite couche d'un oxyde transparent électro-conducteur. De telles couches ou empilements de couches permettent d'influer sur l'aspect en réflexion du vitrage, notamment sur sa couleur en réflexion. Des couleurs bleutées, caractérisées par des coordonnées colorimétriques b* négatives, sont préférées. A titre d'exemples non limitatifs, il est possible d'utiliser une couche d'oxyde mixte de silicium et d'étain (SiSnOₓ), d'oxycarbure ou d'oxynitrure de silicium, d'oxyde d'aluminium, d'oxyde mixte de titane et de silicium. Un empilement de couches comprenant deux couches à haut et bas indice, par exemple un empilement TiOₓ/SiOₓ, SiNₓ/SiOₓ ou ITO/SiOₓ est également utilisable. L'épaisseur physique de cette ou de ces couches est de préférence comprise dans un domaine allant de 5 à 70 nm, notamment de 15 à 30 nm. Les couches ou empilements de neutralisation préférés sont une couche de neutralisation en un oxynitrure de silicium ou un empilement SiNₓ/SiOₓ.

Il est préférable de disposer entre le substrat et la couche ou empilement de neutralisation une couche d'adhésion. Cette couche, qui présente avantageusement un indice de réfraction proche de celui du substrat de verre, permet d'améliorer la tenue à la trempe en favorisant l'accrochage de la couche de neutralisation. La couche d'adhésion est de préférence en silice. Son épaisseur physique est de préférence comprise dans un domaine allant de 20 à 200 nm, notamment de 30 à 150 nm.

Les différents modes de réalisation préférés décrits ci-avant peuvent bien entendu être combinés entre eux. Toutes les combinaisons possibles ne sont pas explicitement décrites dans le présent texte pour ne pas l'alourdir inutilement. Quelques exemples d'empilements particulièrement préférés sont donnés ci-après :
1. Verre / (SiOₓ) / SiOₓN_{y} / ITO / SiNₓ / SiOₓ / (TiOₓ)
2. Verre / SiOₓ / SiNₓ / SiOₓ / ITO / SiNₓ / SiOₓ / (TiOₓ)
3. Verre / SiNₓ / SiOₓ / ITO / SiNₓ / SiOₓ / (TiOₓ)

Dans ces empilements, l'épaisseur physique de la couche (optionnelle) de TiOₓ est avantageusement d'au plus 15 nm, voire 10 nm. L'épaisseur physique e₁ de la couche de TCO est à choisir de manière indépendante, en fonction de l'émissivité voulue, comme expliqué plus avant dans la présente description. L'épaisseur physique e₂ de la couche barrière en nitrure de silicium dépend alors de l'épaisseur e₁ afin d'optimiser les propriétés optiques, de résistivité, et d'émissivité de l'ITO.

Les empilements 1 à 3 sont de préférence obtenus par pulvérisation cathodique magnétron. Les exemples 1 et 2 contiennent sur le verre une couche d'adhésion en silice (optionnelle pour l'exemple 1), puis une couche de neutralisation en oxynitrure de silicium ou un empilement de neutralisation constitué d'une couche de nitrure de silicium surmontée par une couche d'oxyde de silicium, la couche de TCO (en ITO, ou à base d'ITO), une couche barrière en nitrure de silicium, une couche en oxyde de silicium et enfin la couche photocatalytique en oxyde de titane (optionnelle). L'exemple 3 correspond à l'exemple 2, mais sans la couche d'adhésion en silice. Les formules données ne préjugent pas de la stoechiométrie réelle des couches, et d'un éventuel dopage. En particulier le nitrure de silicium et/ou l'oxyde de silicium peut être dopé, par exemple à l'aluminium. Les oxydes et nitrures peuvent ne pas être stoechiométriques (ils peuvent toutefois l'être), d'où l'utilisation dans les formules de l'indice « x », qui n'est bien entendu pas nécessairement le même pour toutes les couches.

Le vitrage selon l'invention est de préférence obtenu par un procédé en plusieurs étapes. Les couches de l'empilement sont déposées sur le substrat de verre, qui se présente alors généralement sous la forme d'une grande feuille de verre de 3,2*6m², ou directement sur le ruban de verre pendant ou juste après le processus de flottage, puis le substrat est découpé aux dimensions finales du vitrage. Après façonnage des bords, on fabrique ensuite le vitrage multiple en associant le substrat à d'autres feuilles de verre, elles-mêmes éventuellement munies au préalable de revêtements fonctionnels, par exemple du type bas-émissif.

Les différentes couches de l'empilement peuvent être déposées sur le substrat en verre par tout type de procédé de dépôt de couche mince. Il peut par exemple s'agir de procédés de type sol-gel, pyrolyse (liquide ou solide), dépôt chimique en phase vapeur (CVD), notamment assisté par plasma (APCVD), éventuellement sous pression atmosphérique (APPECVD), évaporation.

De préférence, les couches de l'empilement sont obtenues par pulvérisation cathodique, notamment assistée par un champ magnétique (procédé magnétron). Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. L'avantage majeur de ce procédé réside dans la possibilité de déposer sur une même ligne un empilement très complexe de couches en faisant successivement défiler le substrat sous différentes cibles, ce généralement dans un seul et même dispositif.

Le procédé magnétron présente toutefois un inconvénient lorsque le substrat n'est pas chauffé lors du dépôt : les couches d'ITO (et éventuellement d'oxyde de titane) ainsi obtenues sont faiblement cristallisées si bien que leurs propriétés respectives d'émissivité et d'activité photocatalytiques ne sont pas optimisées. Un traitement thermique se révèle alors nécessaire.

Ce traitement thermique, destiné à améliorer la cristallisation de la couche d'un oxyde transparent électro-conducteur à base d'oxyde d'étain et d'indium (et optionnellement de la couche photocatalytique), est de préférence choisi parmi les traitements de trempe, de recuit, de recuit rapide. L'amélioration de la cristallisation peut être quantifiée par une augmentation du taux de cristallisation (la proportion massique ou volumique de matière cristallisée) et/ou de la taille des grains cristallins (ou la taille de domaines cohérents de diffraction mesurés par des méthodes de diffraction des rayons X ou de spectroscopie Raman). Cette amélioration de la cristallisation peut aussi être vérifiée de manière indirecte, par l'amélioration des propriétés de la couche. Dans le cas d'une couche de type TCO, l'émissivité diminue, de préférence d'au moins 5% en relatif, voire d'au moins 10% ou 15%, de même que son absorption lumineuse et énergétique. Dans le cas de couches en dioxyde de titane, l'amélioration de la cristallisation se traduit par une augmentation de l'activité photocatalytique. L'activité est généralement évaluée en suivant la dégradation de polluants modèles, tels que l'acide stéarique ou le bleu de méthylène.

Le traitement de trempe ou de recuit est généralement mis en oeuvre dans un four, respectivement de trempe ou de recuisson. L'intégralité du substrat, est portée à une température élevée, d'au moins 300°C dans le cas de la recuisson, et d'au moins 500°C, voire 600°C, dans le cas d'une trempe.

Le recuit rapide est de préférence mis en oeuvre à l'aide d'une flamme, d'une torche plasma ou d'un rayonnement laser. Dans ce type de procédé, on vient créer un mouvement relatif entre le substrat et le dispositif (flamme, laser, torche plasma). Généralement, le dispositif est fixe, et le substrat revêtu vient défiler au regard du dispositif de manière à traiter sa surface. Ces procédés permettent d'apporter une grande densité d'énergie au revêtement à traiter en un temps très faible, limitant ainsi la diffusion de la chaleur vers le substrat, et donc le chauffage dudit substrat. La température du substrat est généralement d'au plus 100°C, voire 50° et même 30°C pendant le traitement. Chaque point de la couche mince est soumis au traitement de recuit rapide pendant une durée généralement inférieure ou égale à 1 seconde, voire 0,5 seconde.

Le traitement thermique de recuit rapide est de préférence mis en oeuvre à l'aide d'un rayonnement laser émettant dans l'infrarouge ou le visible. La longueur d'onde du rayonnement est de préférence comprise dans un domaine allant de 530 à 1200 nm, ou de 600 à 1000 nm, notamment de 700 à 1000 nm, voire de 800 à 1000 nm. On utilise de préférence des diodes laser, émettant par exemple à une longueur d'onde de l'ordre de 808 nm, 880 nm, 915 ou encore 940 nm ou 980 nm. Sous forme de systèmes de diodes, de très fortes puissances peuvent être obtenues, permettant d'atteindre des puissances surfaciques au niveau du revêtement à traiter supérieures à 20kW/cm², voire à 30kW/cm².

Le rayonnement laser est de préférence issu d'au moins un faisceau laser formant une ligne (appelée « ligne laser » dans la suite du texte) qui irradie simultanément toute ou partie de la largeur du substrat. Ce mode est préféré car il évite l'utilisation de systèmes de déplacement coûteux, généralement encombrants, et d'entretien délicat. Le faisceau laser en ligne peut notamment être obtenu à l'aide de systèmes de diodes laser de forte puissance associées à une optique de focalisation. L'épaisseur de la ligne est de préférence comprise entre 0,01 et 1 mm. La longueur de la ligne est typiquement comprise entre 5 mm et 1 m. Le profil de la ligne peut notamment être une courbe de Gauss ou un créneau. La ligne laser irradiant simultanément toute ou partie de la largeur du substrat peut être composée d'une seule ligne (irradiant alors toute la largeur du substrat), ou de plusieurs lignes, éventuellement disjointes. Lorsque plusieurs lignes sont utilisées, il est préférable qu'elles soient disposées de sorte que toute la surface de l'empilement soit traitée. La ou chaque ligne est de préférence disposée perpendiculairement à la direction de défilement du substrat, ou disposée de manière oblique. Les différentes lignes peuvent traiter le substrat simultanément, ou de manière décalée dans le temps. L'important est que toute la surface à traiter le soit. Le substrat peut ainsi être mis en déplacement, notamment en défilement en translation en regard de la ligne laser fixe, généralement en dessous, mais éventuellement au-dessus de la ligne laser. Ce mode de réalisation est particulièrement appréciable pour un traitement en continu. Alternativement, le substrat peut être fixe et le laser peut être mobile. De préférence, la différence entre les vitesses respectives du substrat et du laser est supérieure ou égale à 1 mètre par minute, voire 4 et même 6, 8, 10 ou 15 mètres par minute, ce afin d'assurer une grande vitesse de traitement. Lorsque le substrat est en déplacement, notamment en translation, il peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Le laser peut également être mis en mouvement de manière à ajuster sa distance au substrat, ce qui peut être utile en particulier lorsque le substrat est bombé, mais pas seulement. En effet, il est préférable que le faisceau laser soit focalisé sur le revêtement à traiter de sorte que ce dernier soit situé à une distance inférieure ou égale à 1 mm du plan focal. Si le système de déplacement du substrat ou du laser n'est pas suffisamment précis quant à la distance entre le substrat et le plan focal, il convient de préférence de pouvoir ajuster la distance entre le laser et le substrat. Cet ajustement peut être automatique, notamment régulé grâce à une mesure de la distance en amont du traitement.

Le dispositif de rayonnement laser peut être intégré dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD).

L'invention a aussi pour objet l'utilisation du vitrage selon l'invention pour réduire l'apparition de condensation d'eau (notamment buée ou givre) sur la surface dudit vitrage.

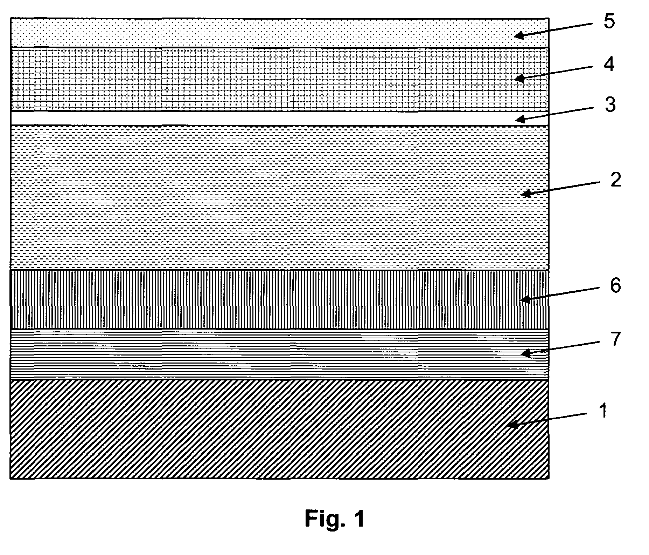

La Figure 1 illustre de manière schématique une coupe d'une partie du vitrage selon l'invention. Seul l'empilement disposé en face 1 du vitrage et une partie du substrat de verre sont représentés.

Sont représentées, déposées sur le substrat 1 (typiquement en verre), la couche 2 d'un oxyde transparent électro-conducteur (typiquement en ITO), la couche barrière 3 à base de nitrure de silicium et la couche à base d'oxyde de silicium 4 (typiquement en SiOₓ). Les couches optionnelles sont la couche photocatalytique 5 (typiquement en TiOₓ), la couche ou l'empilement de neutralisation 6 (typiquement un empilement SiNₓ/SiOₓ) et la couche d'adhésion 7 (par exemple en SiOₓ).

Les exemples qui suivent illustrent l'invention sans toutefois la limiter.

### EXEMPLE 1

On dépose par pulvérisation cathodique magnétron sur un substrat de verre clair de 4 mm d'épaisseur des empilements constitués, en partant du substrat, d'un empilement de neutralisation constitué d'une couche en nitrure de silicium d'environ 20 nm d'épaisseur puis d'une couche en silice d'environ 20 à 30 nm d'épaisseur, puis d'une couche d'ITO, d'une couche barrière en nitrure de silicium, d'une couche d'oxyde de silicium d'environ 50 à 60 nm d'épaisseur, et enfin d'une couche photocatalytique en dioxyde de titane d'environ 7 à 10 nm d'épaisseur. Toutes les épaisseurs sont des épaisseurs physiques.

Les couches d'oxyde de silicium et de nitrure de silicium sont déposées à l'aide de cibles de silicium dopé à l'aluminium (2 à 8% atomiques).

L'épaisseur e₁ de la couche d'ITO est de 120 nm.

L'épaisseur e₂ de la couche barrière en nitrure de silicium varie selon les essais de 12 à 24 nm.

Les feuilles de verre ainsi obtenues sont ensuite trempées thermiquement de manière connue, en chauffant le verre à environ 700°C pendant quelques minutes avant de le refroidir rapidement à l'aide de buses d'air.

Le tableau 1 ci-après récapitule pour les différents essais :
- le rapport e₂/e₁
- la résistance carrée de l'empilement, notée R_{c} et exprimée en Ohms, avant et après trempe, mesurée de manière connue à l'aide d'un dispositif de mesure sans contact commercialisé par la société Nagy Messsysteme GmbH,
- la résistivité électrique de l'empilement, notée ρ et exprimée en Ohms.cm avant et après trempe, calculée à partir de la mesure de la résistance carrée et de l'épaisseur e₁ (déterminée par microscopie électronique à balayage),
- l'absorption lumineuse du substrat revêtu de son empilement, mesurée à partir des spectres optiques en transmission et réflexion, notée A.

**Tableau 1**

| | | C1 | 1 | 2 | C2 |
|---|---|---|---|---|---|
| e₂ (nm) | | 12 | 15 | 16 | 24 |
| e₂/e₁ | | 0,10 | 0,125 | 0,133 | 0,20 |
| R_{c} (Ω) | avant | 110 | 120 | 110 | 110 |
| | après | 29,4 | 15,0 | 15,2 | 19,1 |
| ρ (10⁻⁴ Ω.cm) | avant | 13,0 | 14,4 | 13,0 | 13,0 |
| | après | 3,5 | 1,8 | 1,8 | 2,3 |
| A (%) | avant | 20 | 22 | 20 | 20 |
| | après | 1,9 | 4,0 | 4,2 | 6,3 |

### EXEMPLE 2

Dans cette deuxième série d'exemple, l'épaisseur physique e₁ de la couche d'ITO est de 75 nm. L'épaisseur e₂ varie de 9 à 24 nm en fonction des essais.

Le tableau 2 ci-après regroupe les résultats obtenus.

**Tableau 2**

| | | 3 | C3 | C4 |
|---|---|---|---|---|
| e₂ (nm) | | 9 | 16 | 24 |
| e₂/e₁ | | 0,12 | 0,21 | 0,31 |
| R_{c} (Ω) | avant | 250 | 250 | 250 |
| | après | 26,0 | 30,6 | 39,3 |
| ρ (10⁻⁴ Ω.cm) | avant | 19 | 19 | 19 |
| | après | 1, 95 | 2,33 | 2,93 |
| A (%) | avant | 15 | 15 | 15 |
| | après | 3,2 | 4,4 | 5,2 |

Les exemples C1 à C4 sont des exemples comparatifs, ne respectant pas la condition sur le rapport e₂/e₁. Les exemples 1 à 3 illustrent les avantages de l'invention, et particulièrement l'importance du choix du rapport e₂/e₁. Ce rapport n'influe pas sur les propriétés optiques et de résistivité (et donc d'émissivité) de l'empilement après dépôt. En revanche, ces propriétés mesurées après traitement thermique (ici de trempe) sont grandement influencées par le choix de ce rapport. Lorsque ce dernier est compris dans le domaine selon l'invention, la résistivité (et donc l'émissivité) de l'empilement est optimale après trempe, atteignant une valeur de 1,9.10⁻⁴ Ω.cm ou moins. En revanche, le choix d'épaisseurs de couche barrière trop élevées ou trop faibles s'est révélé dégrader les propriétés de résistivité et d'émissivité du vitrage, et donc ses propriétés d'anti-condensation. Des épaisseurs e₂ trop faibles entraînent une forte augmentation de la résistivité, tandis que des épaisseurs trop fortes s'accompagnent à la fois d'une résistivité élevée et d'une forte absorption lumineuse.

Les vitrages selon l'invention permettent de réduire très fortement l'apparition de condensation d'eau, telle que buée ou givre.

## Revendications

1. Vitrage comprenant un substrat en verre (1) muni sur l'une de ses faces, destinée à former la face 1 dudit vitrage en position d'utilisation, d'un empilement de couches minces comprenant, depuis ledit substrat (1), une couche (2) d'un oxyde transparent électro-conducteur à base d'oxyde d'étain et d'indium d'épaisseur physique e₁ comprise dans un domaine allant de 50 à 200 nm, une couche barrière en nitrure de silicium (3) d'épaisseur physique e₂, puis une couche à base d'oxyde de silicium (4), lesdites épaisseurs e₁ et e₂, exprimées en nanomètres étant telles que 0,11 ≤ e₂/e₁ ≤ 0,18.

2. Vitrage selon la revendication 1, qui est un vitrage multiple, notamment double ou triple.

3. Vitrage selon l'une des revendications précédentes, tel que le substrat en verre (1) est trempé thermiquement.

4. Vitrage selon l'une des revendications précédentes, tel que l'émissivité de la couche (2) d'un oxyde transparent électro-conducteur est inférieure ou égale à 0,4, notamment 0,3.

5. Vitrage selon l'une des revendications précédentes, tel que le rapport e₂/e₁ est compris dans un domaine allant de 0,12 à 0,15.

6. Vitrage selon l'une des revendications précédentes, tel que l'épaisseur physique de la couche à base d'oxyde de silicium (4) est comprise dans un domaine allant de 20 à 100 nm, notamment de 30 nm à 90 nm.

7. Vitrage selon l'une des revendications précédentes, tel que l'on dispose au-dessus de la couche à base d'oxyde de silicium (4) une couche photocatalytique (5) à base d'oxyde de titane, dont l'épaisseur physique est d'au plus 30 nm, notamment 20 nm.

8. Vitrage selon l'une des revendications précédentes, dans lequel on dispose, entre le substrat (1) et la couche (2) d'un oxyde transparent électro-conducteur, une couche, ou un empilement de couches, de neutralisation (6).

9. Vitrage selon la revendication précédente, dans lequel on dispose entre le substrat (1) et la couche ou empilement de neutralisation (6) une couche d'adhésion (7).

10. Vitrage selon l'une des revendications précédentes, tel que l'empilement positionné en face 1 est choisi parmi les empilements suivants :
• Verre / SiOₓ / SiOₓN_{y} / ITO / SiNₓ / SiOₓ / TiOₓ
• Verre / SiOₓ / SiNₓ / SiOₓ / ITO / SiNₓ / SiOₓ / TiOₓ
• Verre / SiNₓ / SiOₓ / ITO / SiNₓ / SiOₓ / TiOₓ

11. Vitrage selon l'une des revendications précédentes, qui est un vitrage triple dans lequel au moins une autre face, choisie parmi les faces 2 à 5, est revêtue d'un empilement à propriétés de faible émissivité, notamment les faces 2 et 5.

12. Procédé d'obtention d'un vitrage selon l'une des revendications précédentes, dans lequel les couches sont déposées par pulvérisation cathodique, puis subissent un traitement thermique destiné à améliorer la cristallisation de la couche (2) d'un oxyde transparent électro-conducteur, ledit traitement thermique étant choisi parmi les traitements de trempe, de recuit, de recuit rapide.

13. Procédé selon la revendication précédente, tel que le recuit rapide est mis en oeuvre à l'aide d'une flamme, d'une torche plasma ou d'un rayonnement laser.

14. Utilisation du vitrage selon l'une des revendications de vitrage précédentes pour réduire l'apparition de condensation d'eau sur la surface dudit vitrage.

## Patentansprüche

1. Verglasung, umfassend ein Glassubstrat (1), das auf einer seiner Seiten, welche dazu bestimmt ist, in Gebrauchsstellung die Seite 1 der Verglasung zu bilden, mit einem Stapel aus dünnen Schichten versehen ist, der von dem Substrat (1) aus eine Schicht (2) aus einem elektrisch leitenden, transparenten Oxid auf der Basis von Zinn- und Indiumoxid mit einer physikalischen Dicke e₁ in einem Bereich von 50 bis 200 nm, eine Sperrschicht aus Siliziumnitrid (3) mit einer physikalischen Dicke e₂, dann eine Schicht auf der Basis von Siliziumoxid (4) umfasst, wobei die in Nanometern ausgedrückten Dicken e₁ und e₂ derart sind, dass 0,11 ≤ e₂/e₁ ≤ 0,18.

2. Verglasung nach Anspruch 1, die eine Mehrfach-, insbesondere Doppel- oder Dreifachverglasung ist.

3. Verglasung nach einem der vorhergehenden Ansprüche, die derart ist, dass das Glassubstrat (1) thermisch vorgespannt ist.

4. Verglasung nach einem der vorhergehenden Ansprüche, die derart ist, dass das Emissionsvermögen der Schicht (2) aus einem elektrisch leitenden, transparenten Oxid geringer als oder gleich 0,4, insbesondere 0,3 ist.

5. Verglasung nach einem der vorhergehenden Ansprüche, die derart ist, dass das Verhältnis e₂/e₁ in einem Bereich von 0,12 bis 0,15 liegt.

6. Verglasung nach einem der vorhergehenden Ansprüche, die derart ist, dass die physikalische Dicke der Schicht auf der Basis von Siliziumoxid (4) in einem Bereich von 20 bis 100 nm, insbesondere von 30 nm bis 90 nm liegt.

7. Verglasung nach einem der vorhergehenden Ansprüche, die derart ist, dass oberhalb der Schicht auf der Basis von Siliziumoxid (4) eine photokatalytische Schicht (5) auf der Basis von Titanoxid angeordnet wird, deren physikalische Dicke höchstens 30 nm, insbesondere 20 nm beträgt.

8. Verglasung nach einem der vorhergehenden Ansprüche, wobei zwischen dem Substrat (1) und der Schicht (2) aus einem elektrisch leitenden, transparenten Oxid ein(e) Neutralisierungsschicht oder -schichtenstapel (6) angeordnet wird.

9. Verglasung nach dem vorhergehenden Anspruch, wobei zwischen dem Substrat (1) und der/dem Neutralisierungsschicht oder -stapel (6) eine Haftschicht (7) angeordnet wird.

10. Verglasung nach einem der vorhergehenden Ansprüche, die derart ist, dass der auf Seite 1 angeordnete Stapel aus den folgenden Stapeln ausgewählt ist:
• Glas / SiOₓ / SiOₓN_{y} / ITO / SiNₓ / SiOₓ / TiOₓ
• Glas / SiOₓ / SiNₓ / SiOₓ / ITO / SiNₓ / SiOₓ / TiOₓ
• Glas / SiNₓ / SiOₓ / ITO / SiNₓ / SiOₓ / TiOₓ

11. Verglasung nach einem der vorhergehenden Ansprüche, die eine Dreifachverglasung ist, bei der wenigstens eine weitere Seite, die aus den Seiten 2 bis 5 ausgewählt ist, mit einem Stapel mit Eigenschaften niedriger Emissivität überzogen ist, insbesondere die Seiten 2 und 5.

12. Verfahren für den Erhalt einer Verglasung nach einem der vorhergehenden Ansprüche, bei dem die Schichten mittels Kathodenzerstäubung abgeschieden werden, anschließend einer Wärmebehandlung unterzogen werden, die dazu bestimmt ist, die Kristallisation der Schicht (2) aus einem elektrisch leitenden, transparenten Oxid zu verbessern, wobei die Wärmebehandlung aus den Behandlungen des Vorspannens, des Ausglühens, des Schnellausglühens ausgewählt ist.

13. Verfahren nach dem vorhergehenden Anspruch, das derart ist, dass das Schnellausglühen mit Hilfe einer Flamme, eines Plasmabrenners oder einer Laserstrahlung durchgeführt wird.

14. Verwendung der Verglasung nach einem der vorhergehenden Verglasungsansprüche, um das Auftreten einer Kondensation von Wasser auf der Oberfläche der Verglasung zu reduzieren.

## Claims

1. A glazing unit comprising a glass substrate (1) equipped on one of its faces, intended to form face 1 of said glazing unit in the use position, with a thin-film multilayer comprising, from said substrate (1), a film (2) of a transparent electrically conductive oxide based on indium tin oxide of physical thickness e₁ comprised in a range extending from 50 to 200 nm, a silicon-nitride barrier film (3) of physical thickness e₂, then a film (4) based on silicon oxide, said thicknesses e₁ and e₂, expressed in nanometers, being such that 0.11 ≤ e₂/e₁ ≤ 0.18.

2. The glazing unit as claimed in claim 1, said glazing unit being a multiple glazing unit, especially a double or triple glazing unit.

3. The glazing unit as claimed in either of the preceding claims, wherein the glass substrate (1) is thermally tempered.

4. The glazing unit as claimed in one of the preceding claims, wherein the emissivity of the film (2) of a transparent electrically conductive oxide is lower than or equal to 0.4 and especially 0.3.

5. The glazing unit as claimed in one of the preceding claims, wherein the ratio e₂/e₁ is comprised in a range extending from 0.12 to 0.15.

6. The glazing unit as claimed in one of the preceding claims, wherein the physical thickness of the film (4) based on silicon oxide is comprised in a range extending from 20 to 100 nm and especially from 30 nm to 90 nm.

7. The glazing unit as claimed in one of the preceding claims, wherein a photocatalytic film (5) based on titanium oxide, the physical thickness of which is at most 30 nm and especially 20 nm, is placed on top of the film (4) based on silicon oxide.

8. The glazing unit as claimed in one of the preceding claims, in which a neutralizing film or film multilayer (6) is placed between the substrate (1) and the film (2) of a transparent electrically conductive oxide.

9. The glazing unit as claimed in the preceding claim, wherein an adhesion film (7) is placed between the substrate (1) and the neutralizing film or multilayer (6).

10. The glazing unit as claimed in one of the preceding claims, wherein the multilayer positioned on face 1 is chosen from the following multilayers:
• Glass / SiOₓ / SiOₓN_{y} / ITO / SiNₓ / SiOₓ / TiOₓ
• Glass / SiOₓ / SiNₓ / SiOₓ / ITO / SiNₓ / SiOₓ / TiOₓ
• Glass / SiNₓ / SiOₓ / ITO / SiNₓ / SiOₓ / TiOₓ

11. The glazing unit as claimed in one of the preceding claims, said glazing unit being a triple glazing unit in which at least one other face, chosen from faces 2 to 5, is coated with a low-E multilayer, especially faces 2 and 5.

12. A process for obtaining a glazing unit as claimed in one of the preceding claims, in which the films are deposited by cathode sputtering, then subjected to a heat treatment intended to improve the crystallization of the film (2) of a transparent electrically conductive oxide, said heat treatment being chosen from tempering, annealing and rapid annealing treatments.

13. The process as claimed in the preceding claim, wherein the rapid anneal is implemented using a flame, a plasma torch or laser radiation.

14. The use of the glazing unit as claimed in one of the preceding glazing unit claims to reduce the appearance of water condensation on the surface of said glazing unit.
